# EUROPEAN PATENT SPECIFICATION

(11) **EP 3 967 525 B1**
(45) Date of publication and mention of the grant of the patent: **11.12.2024**
(21) Application number: 21191039.3
(22) Date of filing: 12.08.2021
(51) Int. Cl.: B60C 23/04, B60C 19/00

(54) **PIEZOELECTRIC TIRE**
PIEZOELEKTRISCHER REIFEN
PNEU PIÉZOÉLECTRIQUE

(30) Priority: 14.09.2020 JP 2020153512
(43) Date of publication of application: 16.03.2022
(73) Proprietor: Sumitomo Rubber Industries, Ltd., Kobe-shi, Hyogo-ken 651-0072 (JP)
(72) Inventor: TAMANO, Akiyoshi, Hyogo 651-0072 (JP); UMINO, Yuuji, Fukushima 960-8157 (JP); KUWATA, Takuya, Fukushima 960-8157 (JP); KANAZAVA, Akihiro, Fukushima 960-8157 (JP)
(74) Representative: Manitz Finsterwald Patent- und Rechtsanwaltspartnerschaft mbB

(56) References cited:
- EP-A2- 1 547 827
- WO-A1-2005/114826
- JP-A- 2014 083 957

## Description

### BACKGROUND OF THE INVENTION

### Field of the Invention

The present invention relates to a piezoelectric tire for generating electric power corresponding to strain of a ground-contact surface of the tire.

### Description of the Background Art

For example, Japanese Laid-Open Patent Publication No. 2006-223054 discloses a tire including a power generation device. The power generation device includes a plurality of power generation elements and a capacitor. Each power generation element includes two elastic electrodes and an elastic polymer compound (dielectric elastomer) interposed between the electrodes. The elastic polymer compound generates a potential difference between the electrodes on the basis of strain generated in the tire. The capacitor stores the electrical energy generated in the power generation element. The plurality of power generation elements are provided at at least one side surface inside the tire on a circumference centered on the rotation axis of the tire. The length in the circumferential direction of each power generation element is set such that strain due to compression caused by the rotating tire coming into the ground and strain due to expansion are not applied to the power generation element at the same time.

In Japanese Laid-Open Patent Publication No. 2006-223054, the two electrodes included in each piezoelectric element (power generation element) are formed by bonding to both surfaces of the dielectric elastomer or by sputtering or vapor deposition. However, the electrodes formed by such a method have a problem about durability. This is because, during running of a vehicle, relatively large tire strain is repeated at a high cycle, and the electrodes are easily peeled off or cracked due to such a harsh usage condition specific to the tire.

A piezoelectric tire in accordance with the preamble of claim 1 is known from WO 2005/114826 A1 and EP 1 547 827 A2. A related tire power generation device is known from JP 2014 083957 A,

The present invention has been made in view of the above circumstances, and an object of the present invention is to suppress peeling or cracking of electrodes included in a piezoelectric element to improve the durability of a piezoelectric tire and further to ensure the amount of power generation of a piezoelectric tire under different load conditions.

### SUMMARY OF THE INVENTION

In order to solve the above problem, the present invention provides a piezoelectric tire with the features of claim 1.

In the present invention, the coating type piezoelectric portion is preferably coated on a back surface of a ground-contact portion of the tire body. In addition, a resin layer may be provided so as to be interposed between the coating type piezoelectric portion and the tire body such that the coating type piezoelectric portion is not in direct contact with the tire body. Moreover, a length in a width direction of the coating type piezoelectric portion is preferably not less than 70% and not greater than 150% of a ground-contact width under a maximum load in a standard of the Japan Automobile Tyre Manufacturers Association, Inc. Furthermore, a length in a circumferential direction of the coating type piezoelectric portion is preferably not less than 40% and not greater than 90% of a ground-contact length under the maximum load in the standard of the Japan Automobile Tyre Manufacturers Association, Inc.

In the present invention, a plurality of the coating type piezoelectric portions are provided at different positions in at least either one of a circumferential direction and a width direction of the tire body. The plurality of the coating type piezoelectric portions have lengths different from each other in the circumferential direction, and may have lengths different from each other in the width direction. In addition, the plurality of the coating type piezoelectric portions may each have a shape obtained by elongating a predetermined shape in at least either one of the circumferential direction and the width direction of the tire body.

In the present invention, the circuit unit may include a wireless circuit configured to wirelessly transmit a signal of a sensor configured to detect a state of an object to be detected, to the outside. In addition, the circuit unit may include a power storage unit configured to store the electric power generated by the piezoelectric portion and supply the stored electric power to the circuit unit.

According to the present invention, since the coating type is used as the piezoelectric portion provided on the tire body, the piezoelectric portion is in close contact with the tire body and flexibly follows strain of the tire body. Accordingly, peeling or cracking of electrodes included in the coating type piezoelectric portion can be suppressed, so that the durability of the piezoelectric tire can be improved.

### BRIEF DESCRIPTION OF THE DRAWINGS

FIG. 1 is a schematic diagram of a piezoelectric tire according to a first embodiment which is not claimed;
FIG. 2 is a cross-sectional view of the piezoelectric tire;
FIG. 3 is a diagram illustrating electromotive force in a piezoelectric portion;
FIG. 4 is a characteristic diagram of FEM analysis in the width direction of a tire;
FIG. 5 is a diagram showing output voltage data at the time of rotation of a tire;
FIG. 6 is a block diagram of a circuit unit;
FIG. 7 is a schematic diagram of a piezoelectric tire according to a second embodiment;
FIG. 8 is an arrangement diagram of a plurality of piezoelectric portions;
FIG. 9 is an arrangement diagram of a plurality of piezoelectric portions according to a first modification; and
FIG. 10 is an arrangement diagram of a plurality of piezoelectric portions according to a second modification.

### DESCRIPTION OF THE PREFERRED EMBODIMENTS

### (First Embodiment)

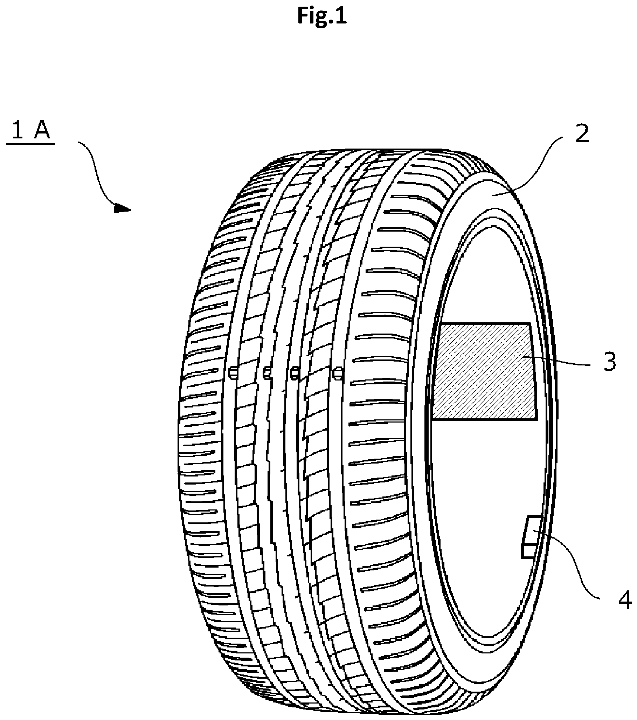

FIG. 1 is a schematic diagram of a piezoelectric tire according to a first embodiment which is not claimed. The piezoelectric tire 1A is mounted to an automobile, and can be widely applied to various vehicles such as motorcycles and bicycles although the shape and size thereof are different. Similar to a general tire, the piezoelectric tire 1A is mainly composed of a tire body 2 formed of an elastic body such as rubber, and a piezoelectric portion 3 and a circuit unit 4 are added to the tire body 2.

The piezoelectric portion 3 is provided on the back surface of a ground-contact portion of the tire body 2 and generates electric power corresponding to strain generated in a ground-contact surface of the tire body 2. The piezoelectric portion 3 includes a pair of electrodes arranged on the upper side and the lower side and a piezoelectric film interposed between the electrodes. In the present embodiment, as the piezoelectric portion 3, a piezoelectric portion coated on the inner surface of the tire body 2, that is, a coating type piezoelectric portion, is used. Examples of the coating mode include silk printing, screen printing, inkjet printing, coating with a bar coater, and spray coating (see, for example, Japanese Laid-Open Patent Publication No. 2018-157950), and bonding, sputtering, and vapor deposition are excluded.

Specifically, the lower electrode is coated on the inner surface of the tire body 2, and the piezoelectric film is formed on the upper part of the lower electrode. As the piezoelectric film, a flexible resin-based piezoelectric material such as polyvinylidene chloride (PVDC), polylactic acid (PLA), polyvinylidene fluoride (PVDF), and a copolymer (PVDF-TrFE)) of vinylidene fluoride (VDF) and trifluoroethylene (TrFE) is used. The upper electrode is formed on the upper part of the piezoelectric film by using the same method as for the lower electrode.

Since a coating type is used as the piezoelectric portion 3, the adhesion to the tire body 2 is improved as compared with a non-coating type such as bonding, sputtering, and vapor deposition. Accordingly, peeling or cracking of the electrodes included in the piezoelectric portion 3 can be suppressed while ensuring the followability of the electrodes to strain of the tire body 2.

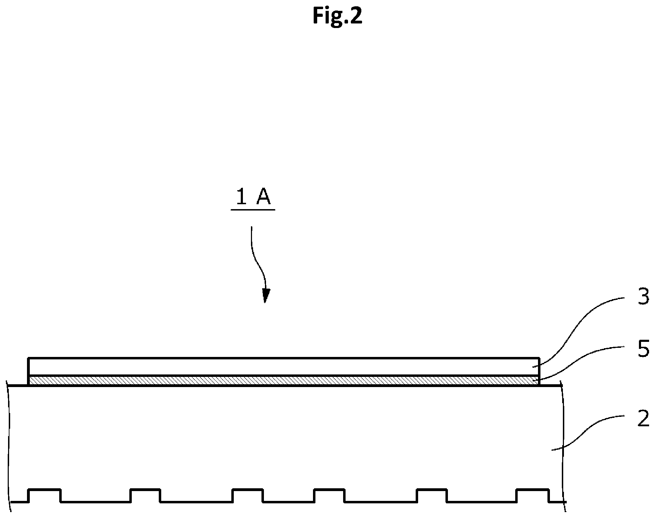

Moreover, as shown in FIG. 2, a resin layer 5 may be interposed between the piezoelectric portion 3 and the tire body 2. Generally, the tire body 2 contains a sulfur component, and a phenomenon (bleed-out) that the sulfur component emerges on the surface of the tire body 2 due to aging, is known. In the case where the piezoelectric portion 3 is in direct contact with the back surface of the tire body 2, the piezoelectric portion 3 may be damaged by the sulfur component that emerges on the surface of the tire body 2, causing deterioration or alteration of the piezoelectric portion 3. In order to solve this problem, the resin layer 5 is interposed between the piezoelectric portion 3 and the tire body 2 as a protective layer for preventing the piezoelectric portion 3 from being in direct contact with the tire body 2. The resin layer 5 is preferably formed by coating such that the resin layer 5 is not easily peeled off from the tire body 2, and preferably does not contain a sulfur component.

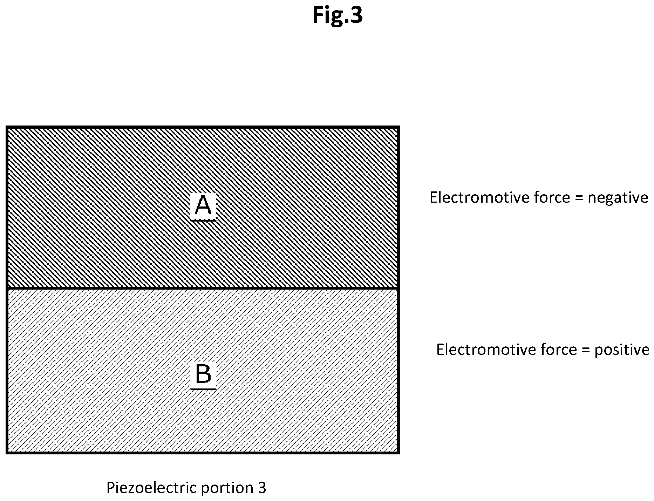

FIG. 3 is a diagram illustrating electromotive force in the piezoelectric portion 3. In general, regardless of whether the piezoelectric portion 3 is a coating type or not, as a characteristic of a single detection surface of the piezoelectric portion 3, if the direction of strain is locally different, for example, if a compression area A to which the strain is applied and an expansion area B in which the strain is relaxed coexist, electromotive force of one polarity (for example, negative) is generated in the compression area A, while electromotive force of the other polarity (for example, positive) is generated in the expansion area B. Accordingly, the electromotive forces of both polarities are cancelled, causing a decrease in the overall electromotive force of the piezoelectric portion 3. The overall electromotive force is maximized when the detection surface is occupied by only an area of one polarity. In addition, the overall electromotive force is minimized when the areas A and B are each present in half. In this case, positive electromotive force and negative electromotive force are completely canceled, so that the overall electromotive force becomes 0. Therefore, when the coating dimensions are set such that coexistence of compression and expansion (in other words, cancellation of positive and negative electromotive forces) is avoided and strain applied to the piezoelectric portion 3 is only compression or expansion, the overall electromotive force can be maximized (amount of power generation can be ensured). This applies to both the circumferential direction and the width direction of the tire.

Specifically, the length in the width direction of the piezoelectric portion 3 was examined by the inventors through experiments and simulations, and as a result, the length in the width direction of the piezoelectric portion 3 is preferably in the numerical range of not less than 70% and not greater than 150% of a ground-contact width under the maximum load in the standard of the Japan Automobile Tyre Manufacturers Association, Inc. (JATMA). Here, a tire rim, load, internal pressure, etc. are quoted from the standard specified by JATMA, and values thereof are uniquely determined for each type of tire.

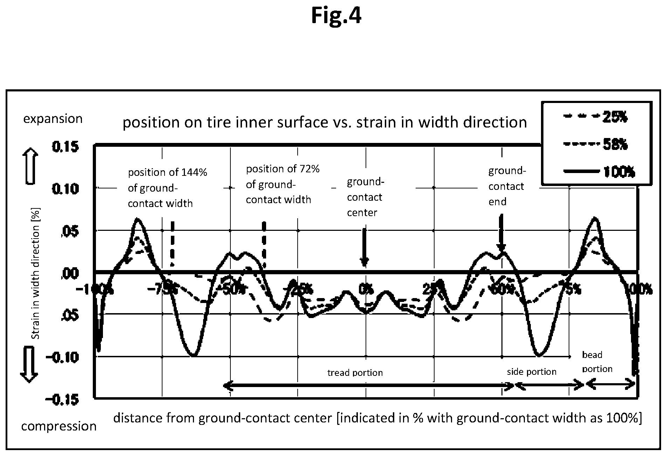

FIG. 4 is a chart obtained by FEM analysis (finite element method analysis) of strain in the width direction in a tire inner surface. In FIG. 4, the horizontal axis indicates the distance from the ground-contact center with a ground-contact width as 100%, in %. Here, the "ground-contact width" refers to the maximum linear distance in the tire axial direction in the surface of the tire that is in contact with a flat plate when the tire is fitted to an applicable rim, the specified air pressure is applied to the tire, the tire is placed on the flat plate so as to be perpendicular to the flat plate in a stationary state, and a load corresponding to a specified mass is applied to the tire. The air pressure and the load capacity are specified in advance in this standard. The vertical axis indicates the strain (%) in the width direction, where the positive side corresponds to expansion and the negative side corresponds to compression. The analysis was carried out with the load applied to the tire being 25%, 58%, and 100% of the maximum load in the JATMA standard. As can be seen from FIG. 4, the strain distribution in the width direction is symmetrical with respect to the ground-contact center (symmetrical on the front side and the back side of the tire).

In the FEM analysis, the strain is negative from the ground-contact center to the positions of ±36% (72% in total) of the ground-contact width under all the three load conditions. Regardless of the magnitude of the load, the strain is in the negative region at positions within 70% that is obtained by taking disturbance factors, variations due to size, etc., into consideration for 72%. In addition, from the ground-contact center to the positions of ±72% (144% in total) of the ground-contact width, the strain is generally in the negative region under the load conditions of 25% and 58%, but a part of the strain is in the positive region under the load condition of 100%, and the positive and negative strains are present as a whole. Under a condition of a low load (under the full-load condition, when the rear tires are braked, etc.), the strain is only in the negative region at positions within 150% that is obtained by taking disturbance factors, variations due to size, etc., into consideration for 144%.

Meanwhile, the length in the circumferential direction of the piezoelectric portion 3 was examined by the inventors through experiments and simulations, and as a result, the length in the circumferential direction of the piezoelectric portion 3 is preferably not less than 40% and not greater than 90% of the ground-contact length under the maximum load in the JATMA standard.

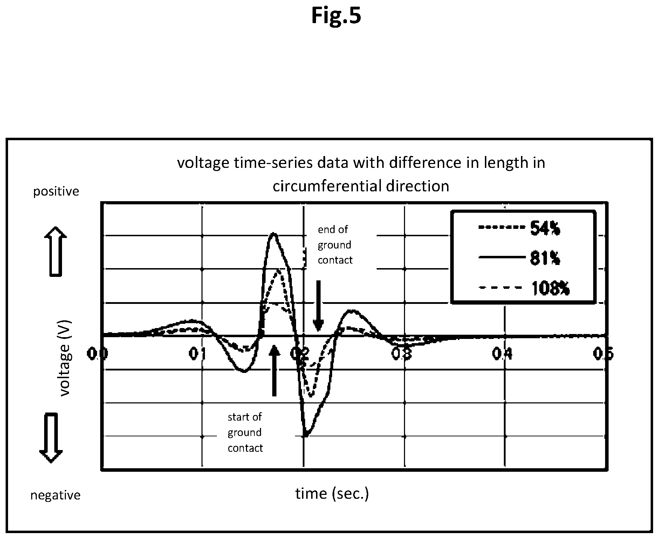

FIG. 5 is a chart showing output voltage data obtained when a load was applied to a tire having the piezoelectric portion 3 coated thereon and the tire was rotated. The horizontal axis indicates time, and the vertical axis indicates an output voltage. Here, the "ground-contact length" refers to the maximum linear distance in the tire circumferential direction in the surface of the tire that is in contact with a flat plate when the tire is fitted to an applicable rim, the specified air pressure is applied to the tire, the tire is placed on the flat plate so as to be perpendicular to the flat plate in a stationary state, and a load corresponding to a specified mass is applied to the tire. The piezoelectric portions coated in this example respectively have lengths equal to 54%, 81%, and 108% of the ground-contact length when the ground-contact length is 100%, and the lengths in the width direction thereof are the same. As can be seen from the time-series waveforms of voltage, a voltage is generated before the piezoelectric portion reaches the ground-contact position and after the piezoelectric portion moves past the ground-contact position. In addition, even if the lengths in the circumferential direction are different, the waveforms are generally similar.

When the voltage level in FIG. 5 is compared, the voltage level is the highest for 81% of the ground-contact length, is second for 54% of the ground-contact length, and is the lowest for 108% of the ground-contact length. The reason why the piezoelectric portion with 108% has a low voltage level even though the piezoelectric element amount is the largest among the three conditions, is that as shown in FIG. 3, an area where strain is compression and an area where strain is expansion coexist in one piezoelectric element, and positive electromotive force and negative electromotive force are cancelled, so that the overall electromotive force is decreased. Therefore, in order to ensure electromagnetic force, the length in the circumferential direction of the piezoelectric portion to be coated needs to be less than the ground-contact length (less than 100% of the ground-contact length). Meanwhile, the length in the circumferential direction by which the tire is deformed by applying a load is the longest at a ground-contact portion on the outermost side, and is the shortest at a tire inner portion due to the thickness of the tread member. In the voltage data in FIG. 5, the voltage level is the highest for the length in the circumferential direction of 81%, and when the length in the circumferential direction is less than 100% and equal to or less than 90% that is obtained by taking disturbance factors, variations due to size, etc., into consideration for 81%, an area where strain is compression and an area where strain is expansion do not coexist in one piezoelectric element

Meanwhile, the load during actual running fluctuates in the range of about 25 to 100%. The ground-contact length under 25% of the maximum load in the JATMA standard is about 47% of that under 100% of the load, and, in order to prevent positive/negative cancellation within one piezoelectric portion 3 under such a condition, the lower limit is set to 40%. That is, the lower limit of 40% is a value that can cover 47% of the ground-contact length under the maximum load since the ground-contact length is shortened to 47% of the ground-contact length when the load is low (under the no-load condition, when the rear tires are braked, etc.).

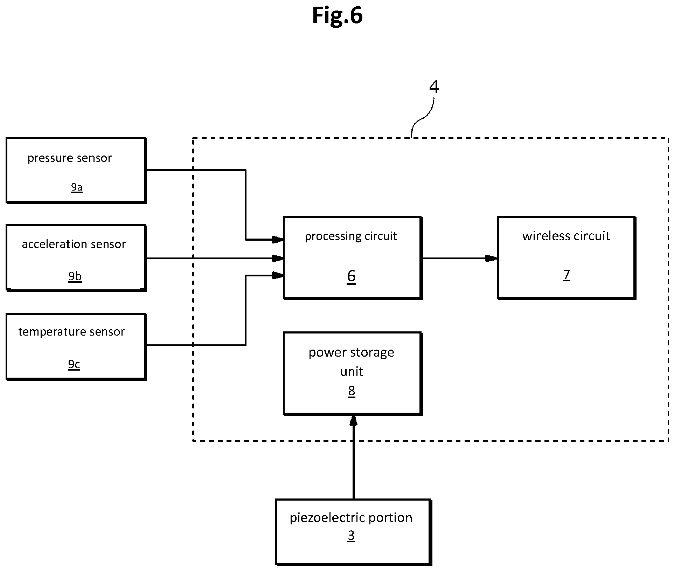

The circuit unit 4 is provided to the tire body 2 and is driven by the electric power generated by the piezoelectric portion 3. FIG. 6 is a block diagram of the circuit unit 4. The circuit unit 4 has a function of wirelessly outputting the output of sensors for detecting the state of an object to be detected, to the outside, and includes a processing circuit 6, a wireless circuit 7, and a power storage unit 8. In the present embodiment, a pressure sensor 9a, an acceleration sensor 9b, and a temperature sensor 9c are provided as the sensors, and are disposed at appropriate locations such as inside the tire body 2 and on the circuit unit 4. The pressure sensor 9a detects the pressure (air pressure) inside the tire body 2. The acceleration sensor 9b detects the acceleration of the tire body 2 due to rotation. In addition, the temperature sensor 9c detects the temperature inside the tire body 2.

The processing circuit 6 performs signal processing such as AD conversion and noise removal on output signals of the multiple sensors 9a to 9c, and outputs the processed signals to the wireless circuit 7. The wireless circuit 7 wirelessly transmits the processed signals of the sensors 9a to 9c to the outside (for example, a computer inside the vehicle). In addition, the power storage unit 8 includes a rechargeable battery and stores the electric power generated by the piezoelectric portion 3. Then, the stored electric power is supplied to the processing circuit 6 and the wireless circuit 7 in the circuit unit 4.

As described above, according to the present embodiment, since the coating type is used as the piezoelectric portion 3 provided on the tire body 2, the piezoelectric portion 3 is in close contact with the tire body 2, so that peeling or cracking of the electrodes included in the piezoelectric portion 3 can be suppressed. As a result, the durability of the piezoelectric tire 1A can be improved without impairing the followability to strain of the tire body 2. In this respect, for example, when a piezoelectric element is formed by a method other than coating such as attaching a film, it is difficult to follow large strain of a tire made of a flexible material, and the electrodes included in the piezoelectric element are easily peeled off or cracked. In addition, when a device-type power generation element is mounted, strain easily becomes uneven or the center of gravity easily deviates. These problems can be effectively solved by using the coating type piezoelectric portion 3.

Moreover, according to the present embodiment, when the length in the width direction of the piezoelectric portion 3 is set to be not less than 70% and not greater than 150% of the ground-contact width under the maximum load in the JATMA standard and/or the length in the circumferential direction of the piezoelectric portion 3 is set to be not less than 40% and not greater than 90% of the ground-contact width under the maximum load in the JATMA standard, it is possible to effectively ensure an amount of power generation.

In the first embodiment described above, the piezoelectric portion 3 is used for supplying electric power to the circuit unit 4, but can also be used as a sensor for detecting the ground-contact state of the tire body 2 on the basis of a change in output voltage. This point also applies to a second embodiment described below.

### (Second Embodiment)

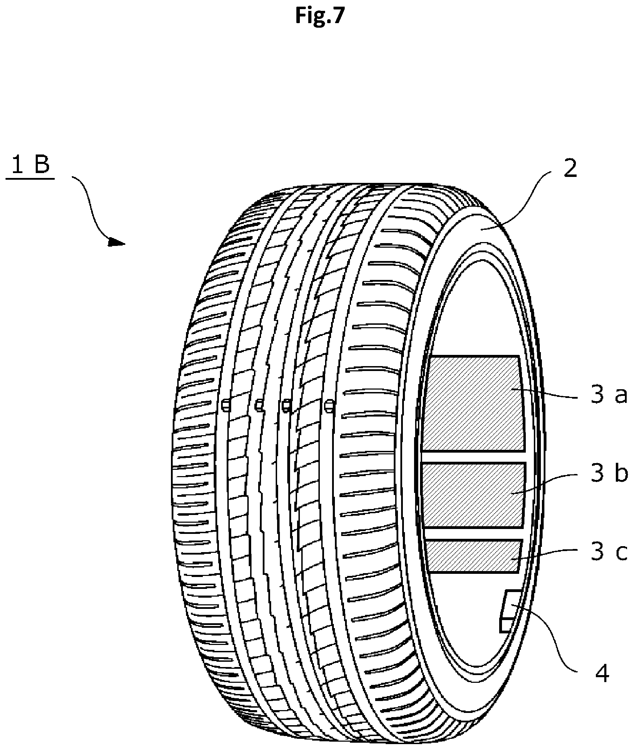

In the second embodiment, a piezoelectric tire in which a plurality of the piezoelectric portions 3 according to the first embodiment are arranged will be described. FIG. 7 is a schematic diagram of the piezoelectric tire according to the second embodiment. The same components as in the first embodiment are designated by the same reference characters, and the description thereof is omitted here.

The piezoelectric tire 1B includes a plurality of piezoelectric portions 3a to 3c provided on the back surface of the ground-contact portion of the tire body 2. These piezoelectric portions 3a to 3c have a predetermined shape, and individually generate electric power corresponding to strain generated in the ground-contact surface of the tire body 2. When the plurality of piezoelectric portions 3a to 3c are arranged at intervals, the total amount of power generation (output voltage) can be increased. In the present embodiment, the three piezoelectric portions 3a to 3c are arranged, but the number of piezoelectric portions arranged is arbitrary. In addition, from the viewpoint of the overall weight balance of the piezoelectric tire 1B, the plurality of piezoelectric portions 3a to 3c may be evenly arranged over the entire circumference of the tire body 2.

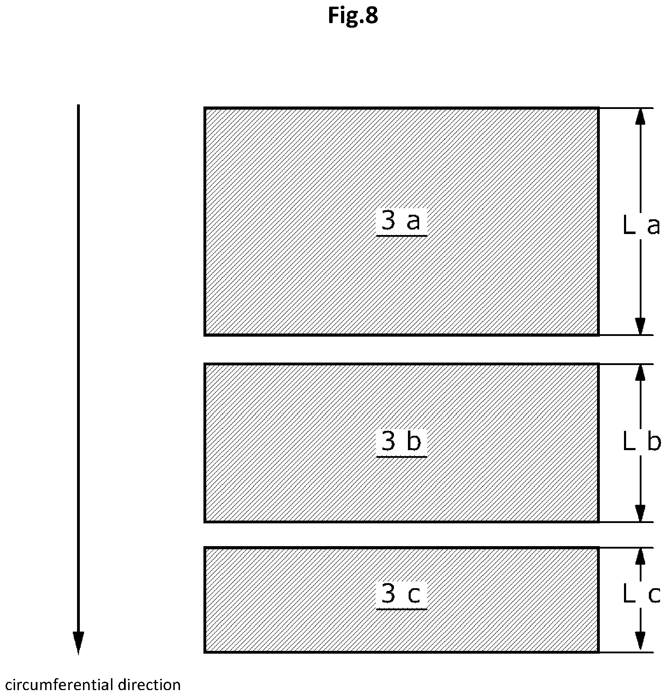

FIG. 8 is an arrangement diagram of the plurality of piezoelectric portions 3a to 3c. The plurality of piezoelectric portions 3a to 3c are provided at positions different from each other in the circumferential direction of the tire body 2. The piezoelectric portions 3a to 3c are all based on a rectangular shape and have a shape obtained by elongating the rectangular shape in the circumferential direction of the tire body 2. That is, the lengths of the piezoelectric portions 3a to 3c in the width direction of the tire body 2 are the same, but the respective lengths La, Lb, and Lc of the piezoelectric portions 3a to 3c in the circumferential direction of the tire body 2 are different from each other (La > Lb > Lc).

The purpose of coating the plurality of piezoelectric portions 3a to 3c having different lengths in the circumferential direction is to ensure an amount of power generation as in the first embodiment described above. The ground-contact length of the tire is proportional to the load, and in actual running, the load fluctuates in the range of 25% to 100% of the ground-contact length under the maximum load in the JATMA standard. The compression/expansion of the piezoelectric portions 3a to 3c also depends on the load. That is, when the lengths in the circumferential direction of the piezoelectric portions 3a to 3c are large and the load is high, only expansion is caused, so that the electromotive force is increased. In addition, when the lengths in the circumferential direction of the piezoelectric portions 3a to 3c are large and the load is low, compression and expansion are caused together, resulting in loss of the electromotive force. On the other hand, when the load is low, a piezoelectric portion having a short length in the circumferential direction causes only expansion, and thus the electromotive force thereof is larger than that of a piezoelectric portion having a long length in the circumferential direction. Therefore, when the plurality of piezoelectric portions 3a to 3c having different lengths in the circumferential direction are coated, electromotive force can be effectively ensured even under any load condition.

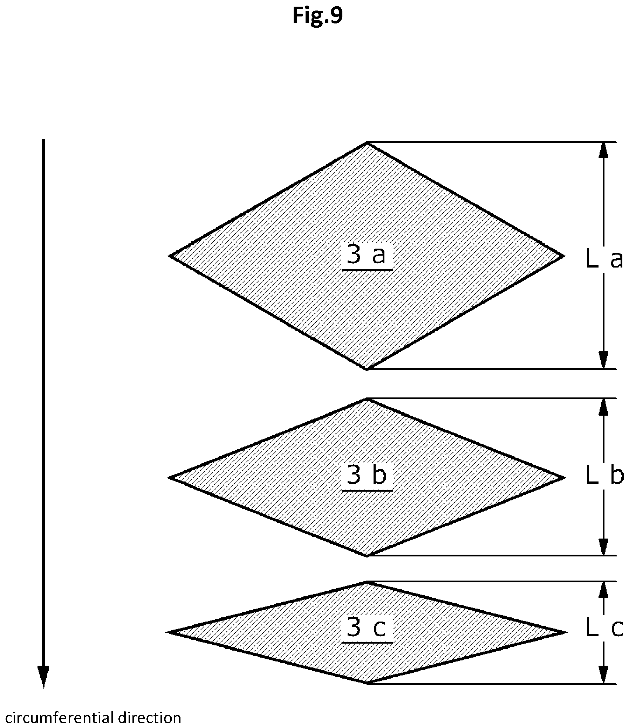

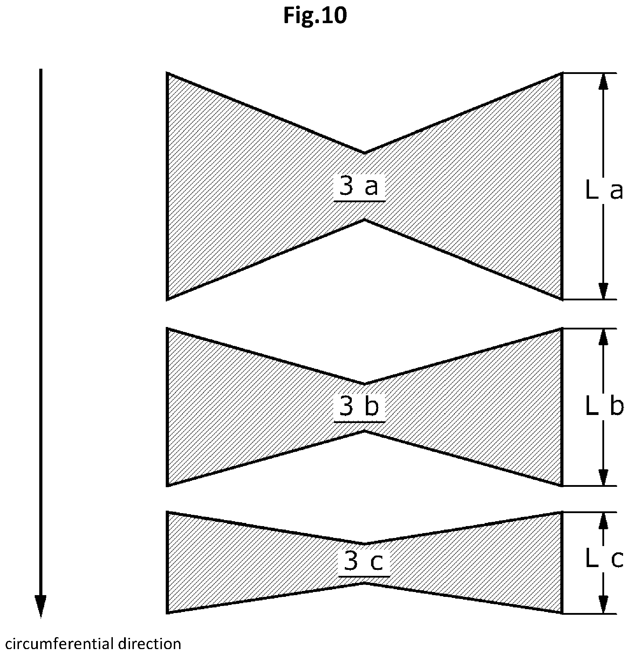

Each of the shapes of the plurality of piezoelectric portions 3a to 3c is not limited to a rectangular shape, and an appropriate shape can be adopted in consideration of the strain shape of the tire body 2 in a ground-contact state. For example, as shown in FIG. 9, a rhombus shape may be used as a base, and the shape of each of the piezoelectric portions 3a to 3c may be a shape obtained by elongating the rhombus shape in the circumferential direction of the tire body 2. Moreover, as shown in FIG. 10, a shape obtained by line-symmetrically arranging two trapezoids may be used as a base, and the shape of each of the piezoelectric portions 3a to 3c may be a shape obtained by elongating this shape in the circumferential direction of the tire body 2.

As described above, according to the present embodiment, since the plurality of piezoelectric portions 3a to 3c having different lengths in the circumferential direction of the tire body 2 are provided, an amount of power generation can be effectively ensured even under any load condition.

In the second embodiment, the example focusing on the circumferential direction of the tire body 2 has been described above, but instead, a plurality of piezoelectric portions may be provided at different positions in the width direction of the tire body 2, or may be provided in both the circumferential direction and the width direction of the tire body 2. In this case, the plurality of piezoelectric portions provided in the width direction may have a shape elongated in the width direction of the tire body 2 as in the case of the circumferential direction.

Furthermore, the present invention can be regarded not only as an invention of a piezoelectric tire, but also as a method for producing a piezoelectric tire, such as forming the piezoelectric portions 3 and 3a to 3c by coating on the tire body 2.

## Claims

1. A piezoelectric tire (1A, 1B) comprising:
a tire body (2);
a coating type piezoelectric portion (3, 3a, 3b, 3c) coated on the tire body (2) and configured to generate electric power corresponding to strain generated in a ground-contact surface of the tire body (2); and
a circuit unit (4) provided to the tire body (2) and driven by the electric power generated by the coating type piezoelectric portion (3, 3a, 3b, 3c),
**characterized in that**
a plurality of the coating type piezoelectric portions (3a, 3b, 3c) are provided at different positions in at least either one of a circumferential direction and a width direction of the tire body (2), and
the plurality of the coating type piezoelectric portions (3a, 3b, 3c) have lengths different from each other in the circumferential direction.

2. The piezoelectric tire (1A, 1B) according to claim 1, wherein the coating type piezoelectric portion (3, 3a, 3b, 3c) is coated on a back surface of a ground-contact portion of the tire body (2).

3. The piezoelectric tire (1A, 1B) according to claim 2, further comprising a resin layer (5) interposed between the coating type piezoelectric portion (3, 3a, 3b, 3c) and the tire body (2) such that the coating type piezoelectric portion (3, 3a, 3b, 3c) is not in direct contact with the tire body (2).

4. The piezoelectric tire (1A, 1B) according to any one of claims 1 to 3, wherein a length in a width direction of the coating type piezoelectric portion (3, 3a, 3b, 3c) is not less than 70% and not greater than 150% of a ground-contact width under a maximum load in a standard of the Japan Automobile Tyre Manufacturers Association, Inc.

5. The piezoelectric tire (1A, 1B) according to any one of claims 1 to 4, wherein a length in a circumferential direction of the coating type piezoelectric portion (3, 3a, 3b, 3c) is not less than 40% and not greater than 90% of a ground-contact length under the maximum load in the standard of the Japan Automobile Tyre Manufacturers Association, Inc.

6. The piezoelectric tire (1B) according to any one of claims 1 to 5, wherein the plurality of the coating type piezoelectric portions (3a, 3b, 3c) have lengths different from each other in the width direction.

7. The piezoelectric tire (1B) according to any one of claims 1 to 6, wherein the plurality of the coating type piezoelectric portions (3a, 3b, 3c) each have a shape obtained by elongating a predetermined shape in the circumferential direction of the tire body (2).

8. The piezoelectric tire (1A, 1B) according to any one of claims 1 to 7, wherein the circuit unit (4) includes a wireless circuit (7) configured to wirelessly transmit a signal of a sensor (9a, 9b, 9c) configured to detect a state of an object to be detected, to the outside.

9. The piezoelectric tire (1A, 1B) according to any one of claims 1 to 8, wherein the circuit unit (4) includes a power storage unit (8) configured to store the electric power generated by the piezoelectric portion (3, 3a, 3b, 3c) and supply the stored electric power to the circuit unit (4).

## Patentansprüche

1. Piezoelektrischer Reifen (1A, 1B), umfassend:
einen Reifenkörper (2);
einen piezoelektrischen Abschnitt vom Beschichtungstyp (3, 3a, 3b, 3c), der auf den Reifenkörper (2) beschichtet ist und konfiguriert ist, um elektrischen Strom zu erzeugen, die einer Dehnung entspricht, die in einer Bodenkontaktfläche des Reifenkörpers (2) erzeugt wird; und
eine Schaltungseinheit (4), die an dem Reifenkörper (2) vorgesehen ist und durch den elektrischen Strom angetrieben wird, der durch den piezoelektrischen Abschnitt vom Beschichtungstyp (3, 3a, 3b, 3c) erzeugt wird,
**dadurch gekennzeichnet, dass**
eine Vielzahl der piezoelektrischen Abschnitte vom Beschichtungstyp (3a, 3b, 3c) an unterschiedlichen Positionen in einer Umfangsrichtung und/oder einer Breitenrichtung des Reifenkörpers (2) vorgesehen sind, und
die Vielzahl der piezoelektrischen Abschnitte vom Beschichtungstyp (3a, 3b, 3c) Längen aufweisen, die sich in der Umfangsrichtung voneinander unterscheiden.

2. Piezoelektrischer Reifen (1A, 1B) nach Anspruch 1, wobei der piezoelektrische Abschnitt vom Beschichtungstyp (3, 3a, 3b, 3c) auf eine Rückfläche eines Bodenkontaktabschnitts des Reifenkörpers (2) beschichtet ist.

3. Piezoelektrischer Reifen (1A, 1B) nach Anspruch 2, ferner umfassend eine Harzschicht (5), die zwischen dem piezoelektrischen Abschnitt vom Beschichtungstyp (3, 3a, 3b, 3c) und dem Reifenkörper (2) derart angeordnet ist, dass der piezoelektrische Abschnitt vom Beschichtungstyp (3, 3a, 3b, 3c) nicht in direktem Kontakt mit dem Reifenkörper (2) ist.

4. Piezoelektrischer Reifen (1A, 1B) nach einem der Ansprüche 1 bis 3, wobei eine Länge in einer Breitenrichtung des piezoelektrischen Abschnitts vom Beschichtungstyp (3, 3a, 3b, 3c) nicht weniger als 70 % und nicht mehr als 150 % einer Bodenkontaktbreite unter einer maximalen Last in einem Standard der Japan Automobile Tyre Manufacturers Association, Inc. beträgt.

5. Piezoelektrischer Reifen (1A, 1B) nach einem der Ansprüche 1 bis 4, wobei eine Länge in einer Umfangsrichtung des piezoelektrischen Abschnitts vom Beschichtungstyp (3, 3a, 3b, 3c) nicht weniger als 40 % und nicht mehr als 90 % einer Bodenkontaktlänge unter der maximalen Last in dem Standard der Japan Automobile Tyre Manufacturers Association, Inc. beträgt.

6. Piezoelektrischer Reifen (1 B) nach einem der Ansprüche 1 bis 5, wobei die Vielzahl der piezoelektrischen Abschnitte vom Beschichtungstyp (3a, 3b, 3c) Längen aufweisen, die sich in der Breitenrichtung voneinander unterscheiden.

7. Piezoelektrischer Reifen (1B) nach einem der Ansprüche 1 bis 6, wobei die Vielzahl der piezoelektrischen Abschnitte vom Beschichtungstyp (3a, 3b, 3c) jeweils eine Form aufweisen, die durch Verlängern einer vorbestimmten Form in der Umfangsrichtung des Reifenkörpers (2) erhalten wird.

8. Piezoelektrischer Reifen (1A, 1B) nach einem der Ansprüche 1 bis 7, wobei die Schaltungseinheit (4) eine drahtlose Schaltung (7) umfasst, die konfiguriert ist, um ein Signal eines Sensors (9a, 9b, 9c), der konfiguriert ist, um einen Zustand eines zu detektierenden Objekts zu detektieren, drahtlos nach außen zu übertragen.

9. Piezoelektrischer Reifen (1A, 1B) nach einem der Ansprüche 1 bis 8, wobei die Schaltungseinheit (4) eine Stromspeichereinheit (8) umfasst, die konfiguriert ist, um den elektrische Strom zu speichern, der durch den piezoelektrischen Abschnitt (3, 3a, 3b, 3c) erzeugt wird, und den gespeicherten elektrischen Strom der Schaltungseinheit (4) zuzuführen.

## Revendications

1. Pneumatique piézoélectrique (1A, 1B) comprenant :
un corps de pneumatique (2) ;
une portion piézoélectrique du type à enrobage (3, 3a, 3b, 3c) enrobée sur le corps de pneumatique (2) et configurée pour générer une puissance électrique correspondant à une contrainte générée dans une surface de contact au sol du corps de pneumatique (2) ; et
une unité de circuit (4) prévue sur le corps de pneumatique (2) et entraînée par la puissance électrique générée par la portion piézoélectrique du type à enrobage (3, 3a, 3b, 3c),
**caractérisé en ce que**
une pluralité de portions piézoélectriques du type à enrobage (3a, 3b, 3c) sont prévues à des positions différentes dans l'une au moins d'une direction circonférentielle et d'une direction de la largeur du corps de pneumatique (2), et
la pluralité de portions piézoélectriques du type à enrobage (3a, 3b, 3c) ont des longueurs différentes les unes des autres dans la direction circonférentielle du pneumatique.

2. Pneumatique piézoélectrique (1A, 1B) selon la revendication 1, dans lequel la portion piézoélectrique du type à enrobage (3, 3a, 3b, 3c) est enrobée sur une surface arrière d'une portion de contact au sol du corps de pneumatique (2).

3. Pneumatique piézoélectrique (1A, 1B) selon la revendication 2, comprenant en outre une couche de résine (5) interposée entre la portion piézoélectrique du type à enrobage (3, 3a, 3b, 3c) et le corps de pneumatique (2) de telle sorte que la portion piézoélectrique du type à enrobage (3, 3a, 3b, 3c) n'est pas en contact direct avec le corps de pneumatique (2).

4. Pneumatique piézoélectrique (1A, 1B) selon l'une quelconque des revendications 1 à 3, dans lequel une longueur dans une direction de la largeur de la portion piézoélectrique du type à enrobage (3, 3a, 3b, 3c) n'est pas inférieure à 70 % et n'est pas supérieure à 150 % d'une largeur de contact au sol sous une charge maximum dans un standard de la Japan Automobile Tyre Manufacturers Association, Inc.

5. Pneumatique piézoélectrique (1A, 1B) selon l'une quelconque des revendications 1 à 4, dans lequel une longueur dans une direction circonférentielle de la portion piézoélectrique du type à enrobage (3, 3a, 3b, 3c) n'est pas inférieure à 40 % et n'est pas supérieure à 90 % d'une longueur de contact au sol sous la charge maximum dans le standard de la Japan Automobile Tyre Manufacturers Association, Inc.

6. Pneumatique piézoélectrique (1B) selon l'une quelconque des revendications 1 à 5, dans lequel la pluralité de portions piézoélectriques du type à enrobage (3a, 3b, 3c) ont des longueurs différentes les unes des autres dans la direction de la largeur.

7. Pneumatique piézoélectrique (1B) selon l'une quelconque des revendications 1 à 6, dans lequel la pluralité de portions piézoélectriques du type à enrobage (3a, 3b, 3c) ont chacune une forme obtenue en allongement une forme prédéterminée dans une direction circonférentielle du corps de pneumatique (2).

8. Pneumatique piézoélectrique (1A, 1B) selon l'une quelconque des revendications 1 à 7, dans lequel l'unité de circuit (4) inclut un circuit sans fil (7) configuré pour transmettre vers l'extérieur, de manière non filaire, un signal d'un capteur (9a, 9b, 9c) configuré pour détecter un état d'un objet à détecter.

9. Pneumatique piézoélectrique (1A, 1B) selon l'une quelconque des revendications 1 à 8, dans lequel l'unité de circuit (4) inclut une unité de stockage de puissance (8) configurée pour stocker la puissance électrique générée par la portion piézoélectrique du type à enrobage (3, 3a, 3b, 3c) et pour alimenter la puissance électrique stockée à l'unité de circuit (4).
